# EUROPEAN PATENT APPLICATION

(11) **EP 2 037 324 A2**
(43) Date of publication of application: **18.03.2009**
(21) Application number: 08252915.7
(22) Date of filing: 02.09.2008
(51) Int. Cl.: G03F 7/20

(54) **Lithographic apparatus and method**

(30) Priority: 13.09.2007 US 898638
(71) Applicant: ASML Netherlands BV, 5504 DR Veldhoven (NL)
(72) Inventor: van Dijk, Paulus Wilhelmus Leonardus, 5032 BH Tilburg (NL); van Buel, Henricus Wilhelmus Maria, 5612 EE Eindhoven (NL); Keijsers, Gerardus Johannes Joseph, 5913 DM Venlo (NL); Onvlee, Johannes, 5211 DX 's-Hertogenbosch (NL); van den Broek, Johannes Arie, 5591 PV Heeze (NL)
(74) Representative: Roberts, Peter David

(57) **Abstract**

A substrate carrier arranged to hold a substrate in position is disclosed. The substrate carrier (WC) has a transparent region (2) that extends through the substrate carrier from a side of the substrate carrier on which the substrate is to be held to an opposite side of the substrate carrier, the transparent region being substantially transparent to a signal used to determine the position of an edge of the substrate on the substrate carrier.

## Description

### FIELD

The present invention relates to a substrate carrier and a method of using that carrier. In particular, although not exclusively, the present invention relates to a substrate carrier and method for use in a lithographic apparatus.

### BACKGROUND

A lithographic apparatus is a machine that applies a desired pattern onto a target portion of a substrate. Lithographic apparatus can be used, for example, in the manufacture of integrated circuits (ICs). In that circumstance, a patterning device, which is alternatively referred to as a mask or a reticle, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the beam in a given direction (the "scanning"-direction) while synchronously scanning the substrate parallel or anti-parallel to this direction.

Traditionally, substrates used in lithography have been one of a relatively small number of sizes and shape. For example, a traditional substrate may be substantially circular in shape, with a diameter of 200 mm (8 inches) or 300 mm (12 inches). The substrate may be, for example, 200 µm thick. However, as technologies which use and depend on lithography develop, the shapes and sizes of substrates used have also changed. Substrates used in modem lithography may be very thin (for example 50 µm, or less), have pits (cavities) in the underside of the substrate, have slots through the substrate or have extremely high bow or warp. Substrates may have rims around their perimeter. The substrates may be irregularly shaped (i.e. non-circular, for example square in shape). In short, the shape and size of substrates used in modern lithography are evolving with the technology which uses the substrates.

### SUMMARY

In order to accommodate different shapes and sizes of the substrates, lithographic apparatus used to pattern the substrates may need to be modified, or new lithographic apparatus created. For example, some lithographic apparatus incorporates equipment which is specifically shaped for dealing with certain sized substrates. Thus, without modification, such lithographic apparatus cannot be used to apply patterns to a non-standard sized (i.e. a non-traditional) substrate.

A proposed way of overcoming a problem of using existing lithographic apparatus to apply a pattern to a non-traditional substrate is the use of an intermediate substrate carrier (or substrate carrier, for short) to which the substrate is removably connected and which is in turn removably connected to a substrate table.

It is desirable to provide, for example, an improved substrate carrier and a method of using that substrate carrier which may obviate or mitigate one or more of the problems of the prior art, whether identified herein or elsewhere.

According to an aspect of the present invention, there is provided a substrate carrier arranged to hold a substrate in position using an electrostatic force, wherein the substrate carrier has a transparent region that extends through the substrate carrier from a side of the substrate carrier on which the substrate is to be held to an opposite side of the substrate carrier, the transparent region being substantially transparent to a signal used to determine the position of an edge of the substrate on the substrate carrier.

The transparent region may comprise a material that is transparent to a signal used to determine the position of an edge of the substrate on the substrate carrier.

The transparent region may be a space which extends through the substrate carrier.

The transparent region may be located such that, when the substrate to be held is located substantially in the center of the substrate carrier, a least a part of an edge of the substrate lies on or across the transparent region.

The transparent region may correspond in general shape to at least a part of an edge of a substrate to be held on the substrate carrier. At least a part of the transparent region may form a transparent ring, a transparent segmented ring or a transparent ring segment. The transparent ring, the transparent segmented ring or the transparent ring segment may have a radius of curvature which is centered on or adjacent to the center of the substrate carrier. The transparent ring, the transparent segmented ring or the transparent ring segment may have an inner radius of curvature which is less than a radius of a substrate to be held on the substrate carrier, and an outer radius of curvature which is greater than a radius of a substrate to be held on the substrate carrier.

The substrate carrier may comprise a plurality of transparent regions. At least a part of the transparent regions may form one or more transparent rings, one or more transparent segmented rings or one or more transparent ring segments. The one or more transparent rings, the one or more transparent segmented rings or the one or more transparent ring segments may have a radius of curvature which is centered on or adjacent to the center of the substrate carrier. At least one of the one or more transparent rings, at least one of the one or more transparent segmented rings or at least one of the one or more transparent ring segments may have an inner radius of curvature which is less than a radius of a substrate to be held on the substrate carrier, and an outer radius of curvature which is greater than a radius of a substrate to be held on the substrate carrier. The substrate carrier may comprise at least two transparent regions comprising a first transparent region and a second transparent region, wherein the first transparent region forms a shape generally similar to that of a first substrate to be held on the substrate carrier, and the second transparent region forms a shape generally similar to that of a second substrate to be held on the substrate carrier.

The substrate carrier may comprises an isolating layer on the side of the substrate carrier on which a substrate is held, the isolating layer, at least at the transparent region, being transparent to a signal to be used to determine the position of an edge of a substrate to be held on the substrate carrier

A surface of the substrate carrier may comprise an array of burls.

According to an aspect of the present invention, there is provided a method of determining the position of an edge of a substrate on a substrate carrier, in use, the substrate being holdable on the substrate carrier using an electrostatic force, the method comprising: directing a signal beam toward a part of the substrate carrier, at least a part of the signal beam passing through a transparent region in the substrate carrier; and determining the position of the edge of the substrate from the at least a part of the signal beam that has passed through the transparent region in the substrate carrier.

The edge of the substrate may be determined using an edge detector. The edge of the substrate may be determined by moving the signal beam. The edge of the substrate may be determined when the signal beam is detected. The edge of the substrate may be determined when the signal beam is no longer detected. The edge of the substrate may be determined by determining what portion of the radiation beam passes through the transparent region of the substrate carrier. Determining what portion of the radiation beam that has passed through the transparent region may comprise determining the intensity of that portion. The intensity of the portion of the radiation beam that has passed through the transparent region of the substrate carrier may be compared with the intensity of the signal beam before it is incident on the substrate. The edge of the substrate may be determined by determining the spatial extent of the portion of the radiation beam that has passed through the transparent region of the substrate carrier.

The method may comprise determnining the position of the edge of the substrate at a plurality of locations.

According to an aspect of the present invention, there is provided a lithographic apparatus comprising: an illumination system configured to condition a beam of radiation; a support structure configured to support a patterning device, the patterning device configured to impart the radiation beam with a pattern in its cross-section; a substrate table configured to hold a substrate carrier; a substrate carrier configured hold in position a substrate using an electrostatic force, the substrate carrier having a transparent region that extends through the substrate carrier from a side of the substrate carrier on which the substrate is to be held to an opposite side of the substrate carrier, the transparent region being substantially transparent to a signal used to determine the position of an edge of the substrate on the substrate carrier; and a projection system configured to project the patterned radiation beam onto a target portion of the substrate.

According to an aspect of the present invention, there is provided a substrate carrier arranged to hold a substrate in position, wherein the substrate carrier has at least one outer width which is smaller than at least one width of a substrate which the substrate carrier is designed to hold.

The substrate carrier may be arranged to hold the substrate in position using an electrostatic force.

The substrate carrier may be shaped such that when a substrate which the substrate carrier is designed to hold is placed on the center of the substrate carrier, a peripheral edge of the substrate extends beyond a peripheral edge of the substrate carrier.

According to an aspect of the present invention, there is provided a method of holding a substrate in position, the method comprising: loading a substrate onto a substrate carrier which has at least one outer width which is smaller than at least one width of the substrate; and holding the substrate in position using the substrate carrier.

Also provided is a method of placing a substrate (e.g., wafer) on a substrate carrier having a transparent region, and placing the substrate carrier and substrate on a substrate table (e.g., wafer table) of a lithographic apparatus.

Also provided is a method of placing a substrate (e.g., wafer) on a substrate carrier, wherein the substrate extends over the edge of the substrate carrier, and placing the substrate carrier and substrate on a substrate table (e.g., wafer table) of a lithographic apparatus.

### BRIEF DESCRIPTION OF THE DRAWINGS

Embodiments of the invention will now be described, by way of example only, with reference to the accompanying schematic drawings in which corresponding reference symbols indicate corresponding parts, and in which:

- Figure 1 depicts a lithographic apparatus according to an embodiment of the invention;

- Figure 2 depicts a substrate carrier in accordance with an embodiment of the present invention;

- Figures 3a and 3b depict a first use of the substrate carrier shown in Figure 2;

- Figures 4a and 4b depict a second use of the substrate carrier shown in Figure 2;

- Figures 5a to 5d depict further substrate carriers in accordance with embodiments of the present invention;

- Figures 6a and 6b depict further substrate carriers in accordance with embodiments of the present invention; and

- Figure 7 depicts a substrate carrier in accordance with an further embodiment of the present invention.

### DETAILED DESCRIPTION

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning device" used herein should be broadly interpreted as referring to a device that can be used to impart a radiation beam with a pattern in its cross-section such as to create a pattern in a target portion of the substrate. It should be noted that the pattern imparted to the radiation beam may not exactly correspond to the desired pattern in the target portion of the substrate. Generally, the pattern imparted to the radiation beam will correspond to a particular functional layer in a device being created in the target portion, such as an integrated circuit.

A patterning device may be transmissive or reflective. Examples of patterning device include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned.

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "projection lens" herein may be considered as synonymous with the more general term "projection system".

The lithographic apparatus may be of a type having two (dual stage) or more substrate tables (and/or two or more patterning device support structures). In such "multiple stage" machines the additional tables and/or structures may be used in parallel, or preparatory steps may be carried out on one or more tables and/or structures while one or more other tables and/or structures are being used for exposure.

The lithographic apparatus may also be of a type wherein the substrate is immersed in a liquid having a relatively high refractive index, e.g. water, so as to fill a space between the final element of the projection system and the substrate. Immersion techniques are well known in the art for increasing the numerical aperture of projection systems.

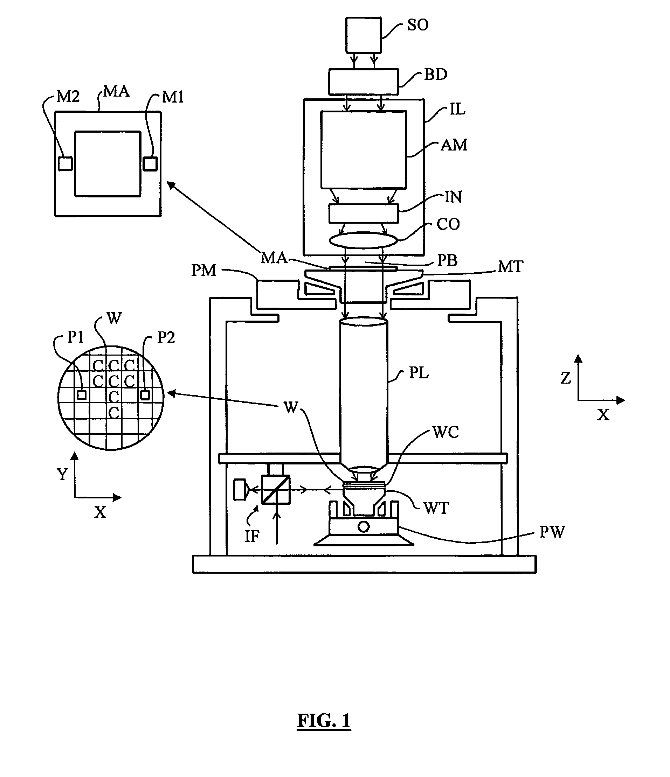

Figure 1 schematically depicts a lithographic apparatus according to a particular embodiment of the invention. The apparatus comprises:
- an illumination system (illuminator) IL to condition a beam PB of radiation (e.g. UV radiation, DUV radiation or EUV radiation);
- a support structure (e.g. a mask table) MT to support a patterning device (e.g. a mask) MA and connected to first positioning device PM to accurately position the patterning device with respect to item PL;
- a substrate table (e.g. a wafer table) WT to hold a substrate carrier WC and connected to second positioning device PW to accurately position a substrate (e.g., a resist coated wafer) W with respect to item PL, the substrate carrier WC being arranged to carry and hold in position the substrate W; and
- a projection system (e.g. a refractive projection lens) PL configured to image a pattern imparted to the radiation beam PB by patterning device MA onto a target portion C (e.g. comprising one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The support structure MT holds the patterning device. It holds the patterning device in a way depending on the orientation of the patterning device, the design of the lithographic apparatus, and other conditions, such as for example whether or not the patterning device is held in a vacuum environment. The support can use mechanical clamping, vacuum, or other clamping techniques, for example electrostatic clamping under vacuum conditions. The support structure MT may be a frame or a table, for example, which may be fixed or movable as required and which may ensure that the patterning device is at a desired position, for example with respect to the projection system. Any use of the terms "reticle" or "mask" herein may be considered synonymous with the more general term "patterning device".

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illumination system may also encompass various types of optical components, including refractive, reflective, and catadioptric optical components for directing, shaping, or controlling the beam of radiation, and such components may also be referred to below, collectively or singularly, as a "lens".

The illuminator IL may comprise adjusting means AM to adjust the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation PB, having a desired uniformity and intensity distribution in its cross-section.

The radiation beam PB is incident on the patterning device (e.g. mask) MA, which is held on the support structure MT. Having traversed the patterning device MA, the beam PB passes through the projection system PL, which focuses the beam onto a target portion C of the substrate W. With the aid of the second positioning device PW and position sensor IF (e.g. an interferometric device), the substrate table WT can be moved accurately, e.g. so as to position different target portions C in the path of the beam PB. Similarly, the first positioning device PM and another position sensor (which is not explicitly depicted in Figure 1) can be used to accurately position the patterning device MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning device PM and PW. However, in the case of a stepper (as opposed to a scanner) the support structure MT may be connected to a short stroke actuator only, or may be fixed. Patterning device MA and substrate W may be aligned using patterning device alignment marks M1, M2 and substrate alignment marks P1, P2.

The depicted apparatus can be used in the following preferred modes:

1. In step mode, the support structure MT and the substrate table WT are kept essentially stationary, while an entire pattern imparted to the beam PB is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the support structure MT and the substrate table WT are scanned synchronously while a pattern imparted to the beam PB is projected onto a target portion C (i.e. a single dynamic exposure). The velocity and direction of the substrate table WT relative to the support structure MT is determined by the (de-) magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.

3. In another mode, the support structure MT is kept essentially stationary holding a programmable patterning device, and the substrate table WT is moved or scanned while a pattern imparted to the beam PB is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

In a proposed lithographic apparatus, an irregular substrate to be exposed to radiation may be attached to a substrate carrier using electrostatic forces. The substrate carrier and substrate attached to the substrate carrier are then loaded into the lithographic apparatus and placed on the substrate table. A vacuum is established between the substrate table and substrate carrier such that the substrate carrier (and thus the substrate) is held in position relative to the substrate table. The substrate carrier may be located on the substrate table using notches, guide walls or the like. The position of the substrate carrier is thus known. However, it is not so easy to determine the position of the substrate relative to the substrate carrier. This means that it is difficult to easily determine the position of the substrate relative to parts of the lithographic apparatus while it is on the substrate carrier, and that it is therefore not easy to accurately apply patterns to the substrate. If patterns are applied to the substrate in the wrong location, even a few nanometers from the intended position, a device of which the pattern is to form a part may not function correctly or at all.

Referring back to Figure 1, an embodiment of the present invention is depicted. In Figure 1, the substrate W is illustrated as being fixed to a substrate carrier WC. The substrate carrier WC is held in position by the substrate table WT. The substrate carrier WC may be held in position using any suitable technique, for example by the use of a vacuum, mechanical clamping or electrostatic clamping. The substrate table WT is provided with one or more mirrors (not shown) which form part of an interferometric device used to accurately position the substrate table WT, and consequently the substrate carrier WC and substrate W which is attached thereto. It will be appreciated that apparatus other than an interferometer device may be used to position the substrate table.

The substrate carrier WC of Figure 1 is readily removable from the lithographic apparatus and introducible into the lithographic apparatus in much the same way as the substrate W of a conventional system. The substrate carrier WC holds the substrate W in position using electrostatic forces in a manner known in the art, such that the substrate carrier WC and substrate W can be moved around without the substrate W becoming detached from the substrate carrier WC. Thus, as the substrate carrier WC is readily removable from and introducible into the lithographic apparatus, the substrate W can be introduced into the lithographic apparatus and removed from the lithographic apparatus while it is attached to the substrate carrier WC. This allows the patterning of the substrate W to take place while the substrate W is attached to (using electrostatic forces) and supported by the substrate carrier WC. Other processing steps may also be undertaken on the substrate while it is attached to (using electrostatic forces) and supported by the substrate carrier WC, for example cleaning of the substrate and coating of the substrate.

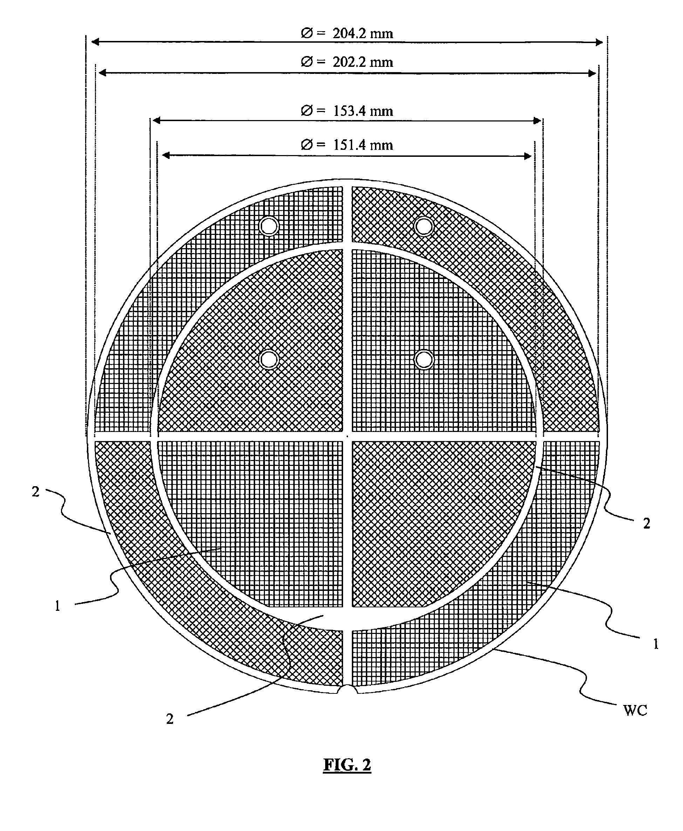

Figure 2 depicts the substrate carrier WC of Figure 1 in more detail. The substrate carrier WC is substantially disc-shaped. The substrate carrier WC is provided with a plurality of clamping sections 1 which are, in use, arranged to electrostatically hold a substrate on the substrate carrier WC. The clamping sections are made from an electrical conductor, for example gold, silver, copper or the like. It can be seen from Figure 2 that the clamping sections 1 are located about the center of the substrate carrier WC. Those clamping sections 1 adjacent to the center of the substrate carrier WC have a substantially circular-sector shape. Those clamping sections 1 remote from the center of the substrate carrier WC have a substantially ring-segment shape. Located between and/or outside the clamping sections 1 is a transparent region 2 which extends through the substrate carrier WC from a side on which a substrate is to be carried to an opposite side of the carrier (e.g. from the top to the bottom of the substrate carrier WC). The transparent region 2 may be formed from glass, and is transparent to electromagnetic radiation which is used to detect the position of edges of a substrate (not shown) on the substrate carrier WC. For example, the transparent region 2 may be transparent to electromagnetic radiation in the visible part of the electromagnetic spectrum. It will be appreciated that the transparent region 2 may be formed from any suitable material which is transparent to the radiation (or other signal) used to detect the edge of the substrate. For example, the transparent region may be formed from fused silica or quartz.

It can be seen from Figure 2 that the transparent region 2 forms two rings which extend around the center of the substrate carrier WC and which are centered on the center of the substrate carrier WC. These rings are positioned and shaped to substantially coincide with a periphery (e.g., circumference) of a substrate to be held in position by the substrate carrier WC. That is, the transparent region 2 which forms the rings has an outer width (e.g., diameter) which slightly exceeds the width (e.g., diameter) of a substrate to be held on the substrate carrier WC, and an inner width (e.g., diameter) which is slightly less than the width (e.g., diameter) of a substrate to be held on the substrate carrier WC. For example, the cross-width of the transparent region 2 which forms the rings may be 2 mm or more when measured in the regional direction from the center of the substrate carrier WC. A cross-width of 2 mm is not essential, however, and other cross-widths may be used.

For example, the accuracy of a handling system for the substrate, as well as other mechanical tolerances, may have an influence on the requirements of the cross-width of the transparent region. The cross-width (e.g. 2 mm) should be such that the substrate can be positioned with sufficient accuracy to ensure that an edge (e.g. a part of an edge, the majority of the circumference, etc) of the substrate falls within the cross-width of the transparent region.

It can be seen that the transparent regions 2 form two rings, both centered on the center of the substrate carrier WC. These rings are both located and shaped to coincide with substrates of different widths. For example, it can be seen that an inner ring has an outer diameter of 153.4 mm and an inner diameter of 151.4 mm. This ring is shaped to coincide with a substrate having a diameter of approximately 152.4 mm (6 inches). An outer ring has an outer diameter of 204.2 mm, and an inner diameter of 202.2 mm. That is, the outer ring is designed to coincide with a substrate having a diameter of approximately 203.2 mm (8 inches). Of course, these ring diameters are given by way of example only, and one or more transparent rings or sections could be provided in a substrate carrier to coincide with a substrate of any shape or width (e.g., diameter), etc.

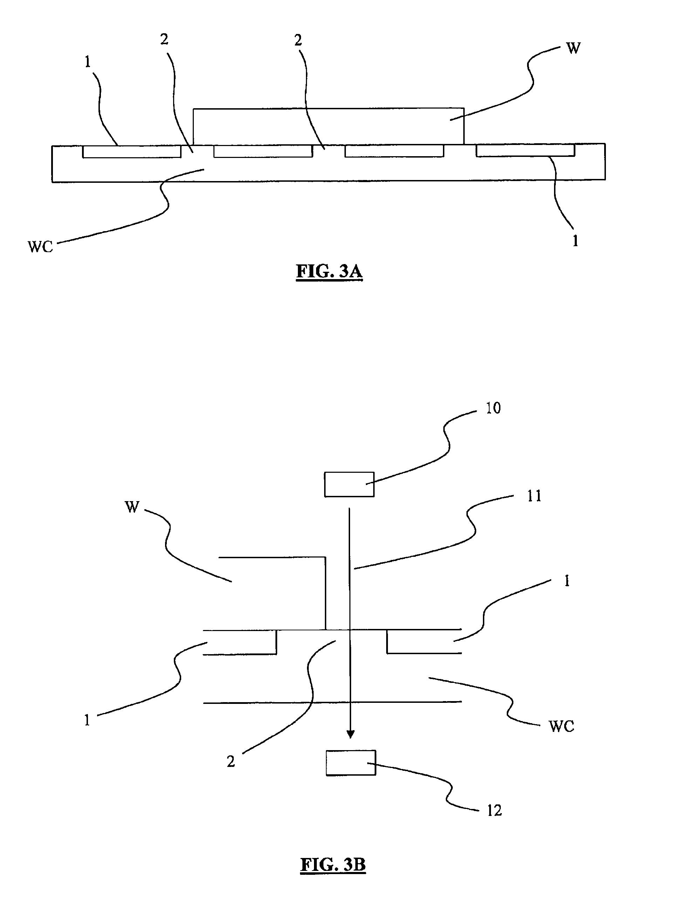

Figures 3a and 3b depict use of the substrate carrier WC of Figure 2. Figure 3a shows a substrate W having a diameter of approximately 152.4 mm (6 inches) placed on the substrate carrier WC. The substrate W may be placed onto the substrate carrier WC using a robot handler or the like, for example. The substrate W is placed in the center of the substrate carrier WC. It can be seen that the diameter of the substrate W is such that it extends across and slightly beyond the clamping sections 1 located adjacent to the center of the substrate carrier WC.

Figure 3b shows a part of Figure 3a. It can be seen that an edge of the substrate W is located between adjacent clamping sections 1, and that the edge of the substrate W is located above a transparent region 2 of the substrate carrier WC. Because the edge of the substrate W is located above a transparent region 2 of the substrate carrier WC, the position of the substrate W on the substrate carrier WC can be accurately and easily determined.

Figure 3b shows a radiation source 10. The radiation source 10 is shown emitting a beam of radiation 11 in the direction of the substrate carrier and alongside the edge of the substrate W. It can be seen that the beam of radiation 11 passes alongside the edge of the substrate W, and through the transparent region 2 of the substrate carrier WC. The beam of radiation 11 is then detected by a radiation detector 12.

The exact location of the edge of the substrate W can be located in any one of a number of ways. An advantage of an embodiment of the present invention is that the transparent region provides a greater contrast against which an edge can be detected. Edge detectors are known in the art which are able to identify the edge of, for example, a substrate. Such an edge detector (for example a one-dimensional image sensor) could therefore be used to determine the position of the edge of the substrate on the substrate carrier. An edge detector may work in any number of ways. For example, a narrow beam of radiation 11 can be scanned across the substrate W and towards its edge until the beam of radiation 11 reaches the edge of the substrate W. At that point, the beam of radiation 11 will no longer be blocked by the substrate W, and will pass alongside the edge of the substrate W, through the transparent region 2, and will be detected by the radiation detector 12. Conversely, a beam of radiation 11 may be scanned from the outer edge of the transparent region 2 in the direction of the substrate W. The beam of radiation 11 will continue to be detected by the radiation detector 12 until the beam of radiation 11 is incident upon the substrate W, at which point the radiation detector 12 cannot detect the beam of radiation 11. In this way, the edge of the substrate W can be accurately determined, and therefore, knowing the width (diameter) of the substrate, the position of the substrate on the substrate carrier can be readily determined. Alternatively, a wide beam of radiation, for example equal in width to the cross-width of the transparent region 2, can be used to illuminate the transparent region 2. The edge of the substrate W can be determined by detecting just how much of the radiation beam 11 is detected by the radiation detector 12. This can be determined, for example, by determining the intensity of the detected radiation beam 11, or by determining the spatial extent of the detected radiation beam 11 (and therefore determining how much of the radiation beam 11 has been blocked out by the substrate W).

Alternatively or additionally, the position of the substrate W may be well known relative to the radiation source 10 and/or detector 12 (or more generally speaking, the edge detector). This means that the actual location of the substrate W on the substrate carrier WC, and the exact location of the substrate carrier WC, may not be that important. The substrate W can still be placed accurately relative to the substrate table WT since the position of the substrate relative to the edge detector (or radiation source, etc.) provides a reference point about or relative to which the substrate can be accurately positioned.

Figure 3b shows how a single edge of the substrate W may be detected. In some circumstances, this may be sufficient. However, it is quite likely that the edge of the substrate W may need to be determined at a plurality of locations to determine the position of the substrate W on the substrate carrier WC. For example, it may be necessary or desirable to determine the position or location of the edge of the substrate W at two, three, four or more equally spaced points along the edge of the substrate W or to determine the position or location of a plurality of edges of the substrate W.

The substrate W is held in position on the substrate carrier WC using electrostatic forces. The use of electrostatic forces to hold a substrate on a substrate carrier is known, and will therefore not be described in more detail here. In brief, an electrostatic force is established within or between clamping regions 1, the force being sufficient to hold the substrate W on the substrate carrier WC. The substrate W may be held in position before, during, or after the location of an edge of the substrate W, and therefore its position on the substrate carrier WC, has been determined.

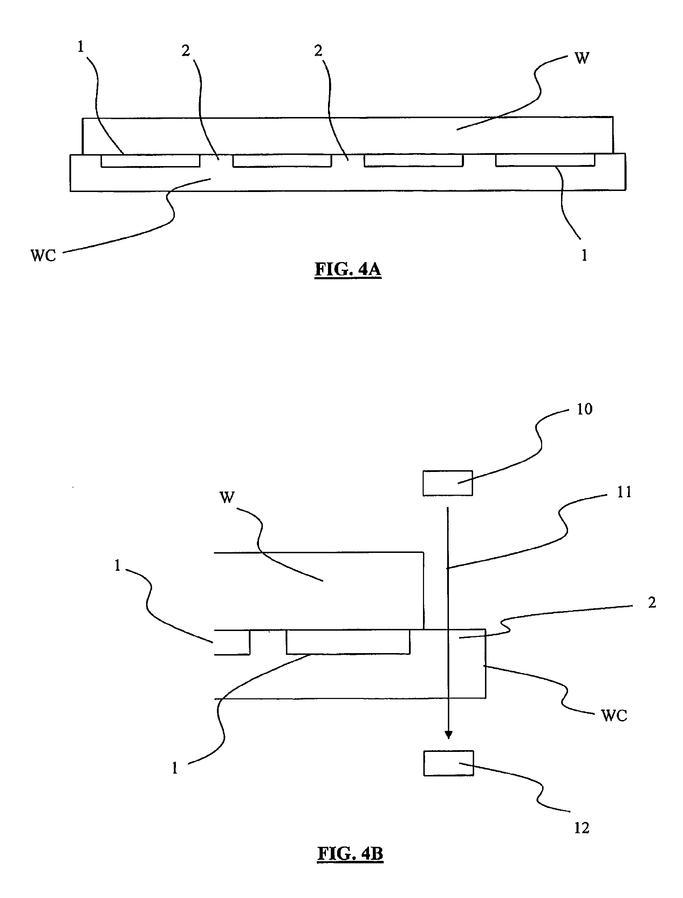

Figure 4a depicts use of the substrate carrier WC with a larger substrate W. A substrate having a diameter of approximately 203.2 mm (8 inches) W is placed on the center of the substrate carrier WC using a robot handler or the like, for example. It can be seen that the diameter of the substrate W is such that the substrate extends across the clamping regions 1 adjacent to the center of the substrate carrier WC, and also across and slightly beyond the clamping regions 1 located about the periphery of the substrate carrier WC.

Figure 4b shows the radiation source 10 emitting a beam of radiation 11 in the direction of the substrate carrier WC and alongside the edge of the substrate W. The beam of radiation 11 passes through the transparent region 2 of the substrate carrier WC and onto the radiation detector 12. The position of the edge of the substrate W and subsequently the position of the substrate W can be determined as described in relation to Figures 3a and 3b.

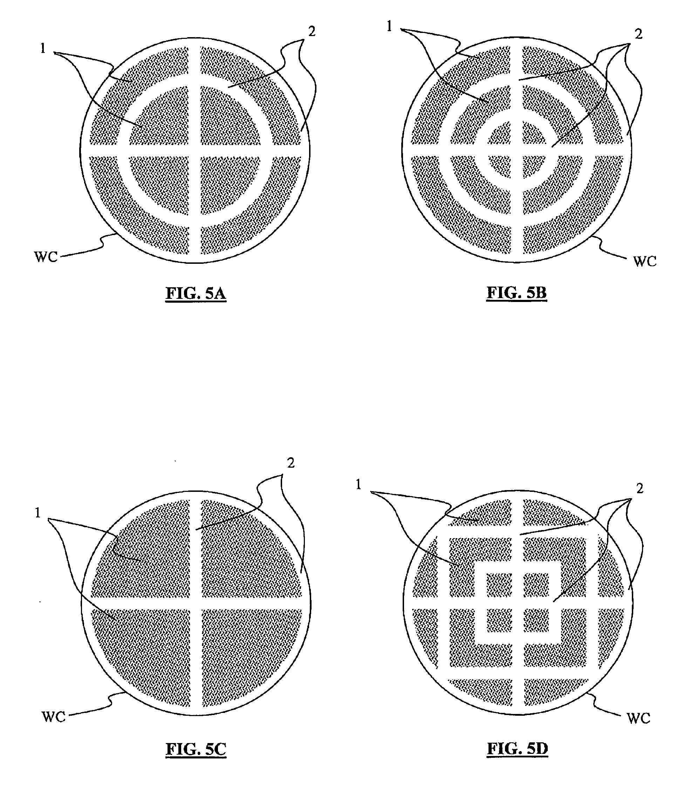

Figure 2 depicted a substrate carrier WC having a transparent region 2 forming rings. The rings were sized to correspond to the edge of substantially circular (e.g., possibly having a notch) substrates having diameters of 152.4 mm (6 inches) and 203.2 mm (8 inches) respectively. However, this arrangement of transparent region is not essential, and many variations of the arrangement of transparent region are possible. For example, Figure 5a shows that the transparent region 2 may form rings having different diameters or relative diameters to those shown in Figure 2. Figure 5b shows that the substrate carrier WC can have more than two rings, for example three rings. The substrate carrier WC of Figure 5b is therefore able to accommodate substrates of three different widths (e.g., diameters). Figure 5c shows that the substrate carrier WC may be provided with a transparent region 2 which forms a single ring for accommodating a specific diameter substrate. The transparent region 2 could form a much larger part of the substrate carrier, allowing it to be used to carry substrates of various different widths while still allowing an edge of those substrate to be accurately determined. Figure 5d illustrates that it is not essential that the transparent region 2 is in the form of circular rings. For example, Figure 5d shows transparent region 2 forming two concentric square rings. These concentric square rings may be used to accommodate square shaped substrates.

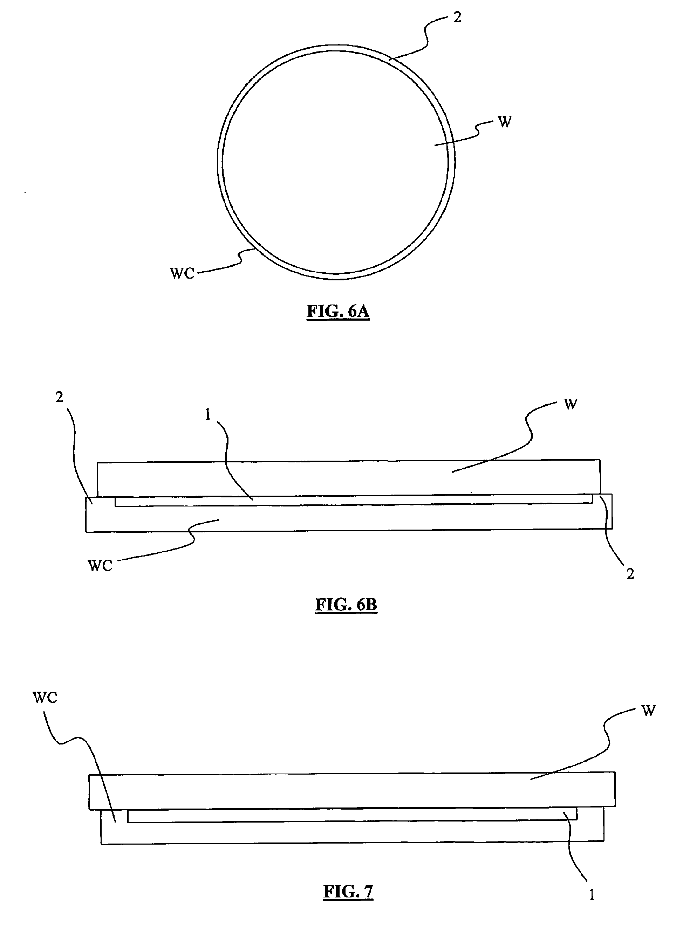

Figures 6a and 6b show another embodiment, where the substrate carrier WC is provided with a single transparent region 2 extending around its periphery. It can be seen that the edge of the substrate W is positioned in the center of the substrate carrier WC, and that the edge of the substrate W lies on the transparent region 2 of the substrate carrier WC. A single clamping region 1 is shown, but it will be appreciated that more than one clamping region 1 may be used.

So far, most of the Figures have shown the clamping sections as being formed as a ring, and/or from circle sectors, and/or from ring segments. Instead, the clamping sections may be formed from a single body of material or the like. A clamping section may form a circle, for example, as opposed to four circle sectors or ring segments as is shown in some of the Figures. It will be appreciated that the use of four segments or sectors is not essential, and that more or less than four segments may be used.

The substrate carrier can be provided with a transparent region which is designed to coincide with any shape of substrate. For example, the transparent region may be square, circular, rectangular, etc. in shape. The transparent region does not necessarily need to form a complete outline of the periphery of the substrate to be held on the substrate carrier. A transparent region can be provided to coincide with some or all parts of the periphery of the substrate. For example, a transparent region can be provided to coincide with corners or parts of the edge(s) of the substrate. The transparent region could, for example, form ring segments, segmented rings or complete rings. The radius of curvature of curved transparent regions will usually be centered on the center of the substrate carrier, but can have common centers (or origins) which are located away from but adjacent to (e.g. within 50 mm, 40 mm, 30 mm, 20 mm, 10 mm, or 5 mm) of the center of the substrate carrier. The transparent region may have, for example, an outer radius which exceeds the radius of a substrate to be held on the substrate carrier, and an inner radius which is slightly smaller than the radius of a substrate to be held on the substrate carrier. This is so that an edge of the substrate will, when on the substrate carrier, be on the transparent region, and therefore be detectable as described above.

The transparent region of the substrate carrier may be discrete channels or sections which are bound or adhered to one or more clamping sections. Additionally or alternatively, one or more clamping sections can be located in recesses (or the like) provided in a transparent body of material. In one embodiment, the transparent region does not need to be formed from a material. Instead, the transparent region may be a space formed in the substrate carrier (e.g. a gap, slit, hole, etc.).

In the above embodiments, the transparent region has been described as being transparent to electromagnetic radiation in the visible part of the electromagnetic spectrum. However, the transparent region may be chosen to be transparent to any particular signal. For example, the transparent region could be transparent to any sort of pressure waves or electromagnetic radiation, etc. The transparent region may be transparent to one or more wavelengths of radiation, or different types of signal or signals. If the transparent region is a gap formed or provided in the substrate carrier, the transparent region may be more transparent to a wider range of signals than if the transparent region were formed from a specific material or mix of materials. The transparent region is transparent in that it lets a signal to be transmitted through the substrate carrier. The transparent region does not need to transmit the entire signal, so long as part of the signal can be detected after it has passed through the substrate carrier. Similarly, the substrate itself is desirably opaque to the radiation (or other signal) used to detect the position of the edge of the substrate. Generally speaking, the substrate should be opaque to the signal for which the transparent region is transparent, so that the edge of the substrate can be easily detected.

In the embodiments described above, the substrate carrier comprises one or more transparent regions, and one or more clamping regions. The substrate carrier may also be provided with an isolating layer. The isolating layer may be provided on top of the substrate carrier WC, that is, the side of the substrate carrier on which the substrate is to be carried and held. The isolating layer may protect a clamping region and transparent region from damage from the substrate, and/or may electrically isolate the substrate from the substrate carrier. The isolating layer should be transparent to the signal used to detect the edge(s) of the substrate, at least at the location of the transparent region. As is known in the art, the top-side of the substrate carrier WC (i.e. the side of the substrate carrier on which a substrate is to be held) may also be provided with an array of burls on which the substrate may be carried and held. Contamination can fall in the spaces between burls. This reduces the probability of contamination falling onto the surface on to which the substrate is placed (e.g. the top of the burls), and thus reduces the probability of contamination on the substrate carrier affecting the flatness of a substrate when carried and held by the substrate carrier.

In the embodiments described thus far, the substrate carrier is generally larger in width than the substrate which it is designed to hold. An advantage of those embodiments is that the transparent region provides a greater contrast against which an edge of the substrate can be detected. According to a further embodiment of the present invention, greater contrast can be achieved by using a substrate carrier which has at least one outer width which is smaller than at least one width of a substrate which the substrate carrier is designed to hold. This means that an edge of the substrate will overhang the edge of the substrate carrier, and that this edge can be more readily detected using, for example, the methods described above. As shown in Figure 7, the substrate carrier WC maybe shaped such that when a substrate W which the substrate carrier WC is designed to hold is placed on the center of the substrate carrier WC, a peripheral edge of the substrate W extends beyond a peripheral edge of the substrate carrier WC. This means that the location of one or more edges or parts of one or more edges of the substrate W can be determined more readily. As described above, the substrate carrier WC may be arranged to hold the substrate in position using an electrostatic force.

Although the embodiments have so far been described in relation to optical lithography, the substrate carriers can also be used in other situations. For example, the substrate carriers may be used to carry and hold substrates in processing stages, such as spin-coating modules or cleaning modules. The substrate carriers can also be used to carry and hold in position substrates to be used in imprint lithography, where an imprint template (sometimes referred to as a stamp) is pressed into or against layer of material (e.g. an imprintable medium) provided on the substrate.

While specific embodiments of the invention have been described above, it will be appreciated that the invention may be practiced otherwise than as described. The description is not intended to limit the invention, the invention being limited by the claims that follow.

## Claims

1. A substrate carrier arranged to hold a substrate in position using an electrostatic force, wherein the substrate carrier has a transparent region that extends through the substrate carrier from a side of the substrate carrier on which the substrate is to be held to an opposite side of the substrate carrier, the transparent region being substantially transparent to a signal used to determine the position of an edge of the substrate on the substrate carrier.

2. The substrate carrier of claim 1, wherein the transparent region comprises a material that is transparent to a signal used to determine the position of an edge of the substrate on the substrate carrier.

3. The substrate carrier of claim 1, wherein the transparent region is a space which extends through the substrate carrier.

4. The substrate carrier of any preceding claim, wherein the transparent region is located such that, when the substrate to be held is located substantially in the center of the substrate carrier, a least a part of an edge of the substrate lies on or across the transparent region.

5. The substrate carrier of any preceding claim, wherein the transparent region corresponds in general shape to at least a part of an edge of a substrate to be held on the substrate carrier.

6. The substrate carrier of any preceding claim, wherein at least a part of the transparent region forms a transparent ring, a transparent segmented ring or a transparent ring segment.

7. The substrate carrier of claim 6, wherein the transparent ring, the transparent segmented ring or the transparent ring segment has a radius of curvature which is centered on or adjacent to the center of the substrate carrier.

8. The substrate carrier of claim 6 or claim 7, wherein the transparent ring, the transparent segmented ring or the transparent ring segment has an inner radius of curvature which is less than a radius of a substrate to be held on the substrate carrier, and an outer radius of curvature which is greater than a radius of a substrate to be held on the substrate carrier.

9. The substrate carrier of any preceding claim, comprising a plurality of transparent regions.

10. The substrate carrier of claim 9, wherein at least a part of the transparent regions form one or more transparent rings, one or more transparent segmented rings or one or more transparent ring segments.

11. The substrate carrier of claim 10, wherein the one or more transparent rings, the one or more transparent segmented rings or the one or more transparent ring segments have a radius of curvature which is centered on or adjacent to the center of the substrate carrier.

12. The substrate carrier of claim 10 or claim 11, wherein at least one of the one or more transparent rings, at least one of the one or more transparent segmented rings or at least one of the one or more transparent ring segments has an inner radius of curvature which is less than a radius of a substrate to be held on the substrate carrier, and an outer radius of curvature which is greater than a radius of a substrate to be held on the substrate carrier.

13. The substrate carrier of any preceding claim, comprising at least two transparent regions comprising a first transparent region and a second transparent region, wherein the first transparent region forms a shape generally similar to that of a first substrate to be held on the substrate carrier, and the second transparent region forms a shape generally similar to that of a second substrate to be held on the substrate carrier.

14. The substrate carrier of any preceding claim, comprising an isolating layer on the side of the substrate carrier on which a substrate is held, the isolating layer, at least at the transparent region, being transparent to a signal to be used to determine the position of an edge of a substrate to be held on the substrate carrier.

15. The substrate carrier of any preceding claim, wherein a surface of the substrate carrier comprises an array of burls.

16. A lithographic apparatus comprising:
an illumination system configured to condition a beam of radiation;
a support structure configured to support a patterning device, the patterning device configured to impart the radiation beam with a pattern in its cross-section;
a substrate table configured to hold a substrate carrier;
a substrate carrier as claimed in any preceding claim; and
a projection system configured to project the patterned radiation beam onto a target portion of the substrate.

17. A method of determining the position of an edge of a substrate on a substrate carrier, in use, the substrate being holdable on the substrate carrier using an electrostatic force, the method comprising:
directing a signal beam toward a part of the substrate carrier, at least a part of the signal beam passing through a transparent region in the substrate carrier; and
determining the position of the edge of the substrate from the at least a part of the signal beam that has passed through the transparent region in the substrate carrier.
